# EUROPÄISCHE PATENTANMELDUNG

(11) **EP 1 577 723 A1**
(43) Veröffentlichungstag der Anmeldung: **21.09.2005**
(21) Anmeldenummer: 04006637.5
(22) Anmeldetag: 19.03.2004
(51) Int. Cl.: G05B 19/042, H04B 5/00, H05K 7/14, G05B 19/05

(54) **Modulare Steuerung mit drahtloser Verbindung der Module**

(71) Anmelder: Murr-Elektronik Gesellschaft mit beschränkter Haftung, 71570 Oppenweiler (DE)
(72) Erfinder: Bauermeister, Ralf, 71332 Waiblingen (DE)
(74) Vertreter: Riedel, Peter

(57) **Zusammenfassung**

Die Erfindung betrifft eine modular aufgebaute Steuerung für Fertigungsanlagen. In einem selbständigen Gehäuse (4) ist ein Masterbaustein (3), und seitlich neben dem Masterbaustein (3) in jeweils selbständigen Gehäusen (4) sind Slavebausteine (2) angeordnet. Jeder Slavebaustein (2) hat Ein- und/oder Ausgänge (11) zur Verbindung mit Sensoren und/oder Aktoren. Der Masterbaustein (3) sowie der Slavebaustein (2) kommunizieren zum Austausch von Daten- und/oder Steuerungsbefehlen über einen Datenbus (13), wobei zur Busverbindung zwischen den Bausteinen (2) je eine Schnittstelle (15, 16) vorgesehen ist. Nach der Erfindung liegen die Schnittstelle (16) des Masterbausteins (3) und die Schnittstelle (15) des Slavebausteins (2) etwa auf gleicher Höhe (H) mit geringem Abstand einander gegenüber, wobei die Schnittstellen (15 und 16) drahtlos miteinander in Verbindung stehen.

## Beschreibung

Die Erfindung betrifft eine modular aufgebaute Steuerung, insbesondere für Fertigungsanlagen, Maschinen oder dgl. nach dem Oberbegriff des Anspruchs 1.

Es ist bekannt, derartige modulare Steuerungsanlagen der Schutzart IP 20 in Schaltschränken anzuordnen, wobei der Masterbaustein mit einem externen Datenbus in Verbindung steht und die Slavebausteine mit Ein- und/oder Ausgängen zur Verbindung mit Sensoren und/oder Aktoren versehen sind. Um die über den Datenbus zugeführten Steuerungsbefehle vom Masterbaustein auf die Slavebausteine zu übertragen, sind Kabelbrücken vorgesehen, die jeweils von einem Baustein zum anderen Baustein zu stecken sind. Das Einstecken dieser mehradrigen Kabelbrücken ist aufwendig und in engen Schaltschränken oft mit Problemen verbunden.

Der Erfindung liegt die Aufgabe zugrunde, ein modular aufgebautes Steuerungssystem anzugeben, das einfach und zeitsparend montiert werden kann.

Die Aufgabe wird erfindungsgemäß nach den Kennzeichen des Anspruchs 1 gelöst. Die Schnittstelle des Masterbausteins und die Schnittstelle des Slavebausteins liegen etwa auf gleicher Höhe mit geringem Abstand einander gegenüber, wobei die Schnittstellen drahtlos miteinander in Verbindung stehen.

Aufgrund der Anordnung und der Ausbildung der Schnittstellen kann ein Slavebaustein in einfacher Weise neben dem Masterbaustein auf einer Befestigungsschiene aufgereiht werden, wobei der mit geringem Abstand neben dem Masterbaustein oder an der Gehäuseseite des Masterbausteins anliegende Slavebaustein über die drahtlose Schnittstelle an den Datenbus angeschlossen ist. Ein derartiger Datenbus kann z.B. ein CAN-Bus sein, wie er in modularen Steuerungsanlagen an sich bekannt ist.

Bevorzugt ist auf einer Gehäuseseite eines Bausteins eine erste Schnittstelle und auf einer anderen Gehäuseseite des Bausteins eine weitere Schnittstelle vorgesehen, wobei die Schnittstellen eines Bausteins zweckmäßig auf einander abgewandten Gehäuseseiten liegen. Da die Schnittstelle der einen Gehäuseseite und die Schnittstelle der anderen Gehäuseseite auf gleicher Höhe angeordnet werden, können mehrere Bausteine nebeneinander auf einer Befestigungsschiene aufgereiht werden, wobei die jeweils nebeneinander liegenden Schnittstellen miteinander drahtlos in Verbindung treten. Auf diese Weise können mehrere Slavebausteine in einer Reihe neben einem Masterbaustein angeordnet werden; der Datenbus wird dabei über die Schnittstellen durch alle Slavebausteine durchgeschleift. Für einen CAN-Bus wird das Tₓ-Signal eines Microprozessors direkt zurückgeleitet auf das Rₓ-Signal, so daß eine Arbitrierung des CAN möglich ist. Für die Initialisierung des einzelnen Bausteins besteht die Möglichkeit, das Sendesignal abzuschalten.

Bevorzugt besteht jede Schnittstelle aus einem Eingang und aus einem Ausgang, wobei der Eingang auf der einen Gehäuseseite und ein Ausgang auf der anderen Gehäuseseite auf gleicher Höhe liegt.

Die drahtlose Verbindung wird zweckmäßig als optische Verbindung ähnlich einem Optokoppler gestaltet, wobei die optische Verbindung im Infrarotbereich arbeitet, so daß sie tageslichtunabhängig ist. Grundsätzlich sind auch andere drahtlose Verbindungen wie Funkverbindungen, induktive Verbindungen, akustische Verbindungen oder dgl. möglich.

In einem bevorzugten Ausführungsbeispiel liegen zwischen der Schnittstelle des einen Bausteins und der Schnittstelle des anderen Bausteins die Gehäusewände der Gehäuse der beiden Bausteine, so daß die drahtlose Verbindung durch die Gehäusewände dringen muß. Auf diese Weise können die einzelnen Bausteine mit hermetisch geschlossenen Gehäusen staubdicht ausgebildet werden, was insbesondere in stark verschmutzten Arbeitsbereichen vorteilhaft ist. Bei der Auslegung der Verbindung als optische Verbindung werden die Gehäusewände der Bausteine zumindest im Bereich der Schnittstellen lichtdurchlässig ausbildet, insbesondere infrarotdurchlässig ausgebildet. Bevorzugt sind die Gehäuse der Bausteine vorzugsweise einteilig aus einem infrarotdurchlässigen Kunststoff gefertigt.

Weitere Merkmale der Erfindung ergeben sich aus den weiteren Ansprüchen, der Beschreibung und der Zeichnung, in der Ausführungsbeispiele der Erfindung im einzelnen beschrieben sind.

Es zeigen:
- Fig. 1: in schematischer Darstellung eine modular aufgebaute Steuerung auf einer Hutschiene in einem Schaltschrank,
- Fig. 2: in schematischer Darstellung einen Baustein der modularen Steuerung nach Fig. 1,
- Fig. 3: eine perspektivische Darstellung eines Masterbausteins der modularen Steuerung nach Fig. 1,
- Fig. 4: in perspektivischer Darstellung einen Masterbaustein gemäß Fig. 3 mit geschlossenem Gehäuse,
- Fig. 5: in perspektivischer Darstellung einen Slavebaustein mit geschlossenem Gehäuse,
- Fig. 6: in perspektivischer Darstellung einen weiteren Masterbaustein mit geschlossenem Gehäuse.

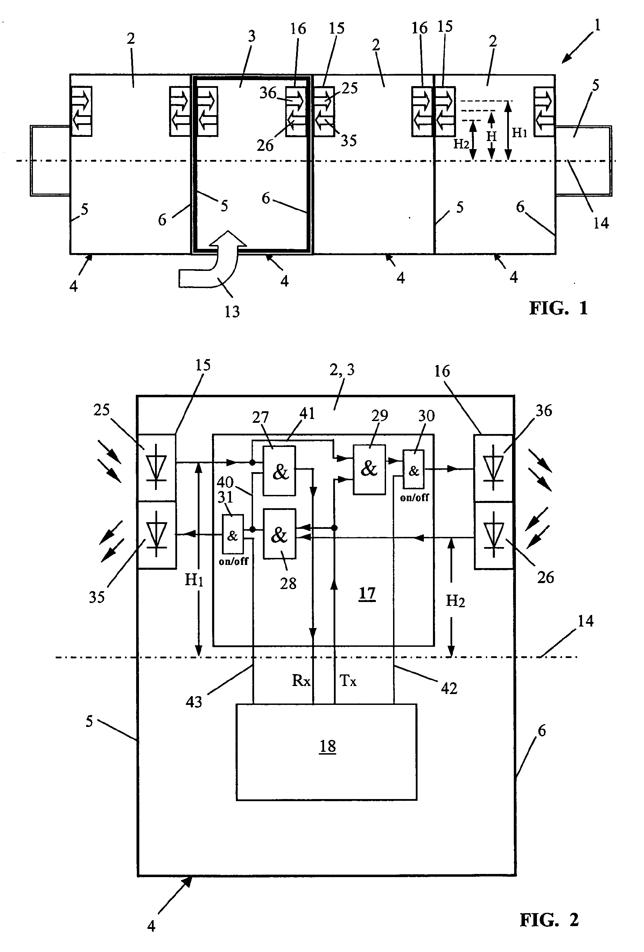

Die in Fig. 1 dargestellte Steuerung wird z.B. für Fertigungsanlagen, Maschinen oder dgl. verwendet. Die Steuerung 1 ist modular aufgebaut und besteht aus einzelnen Bausteinen 2 und 3, wobei jeder Baustein in einem geschlossenen, selbstständigen Gehäuse 4 angeordnet ist. Wie in Fig. 1 gezeigt, werden die Gehäuse 4 auf einer Befestigungsschiene 5, z.B. eine Hutschiene, festgelegt, wobei die Gehäuse 4 in einer Reihe nebeneinander liegen und die orthogonal zu der Befestigungsschiene 5 liegenden Gehäuselängsseiten 5, 6 benachbarter Gehäuse 4 etwa parallel nebeneinander liegen, bevorzugt aneinander anliegen.

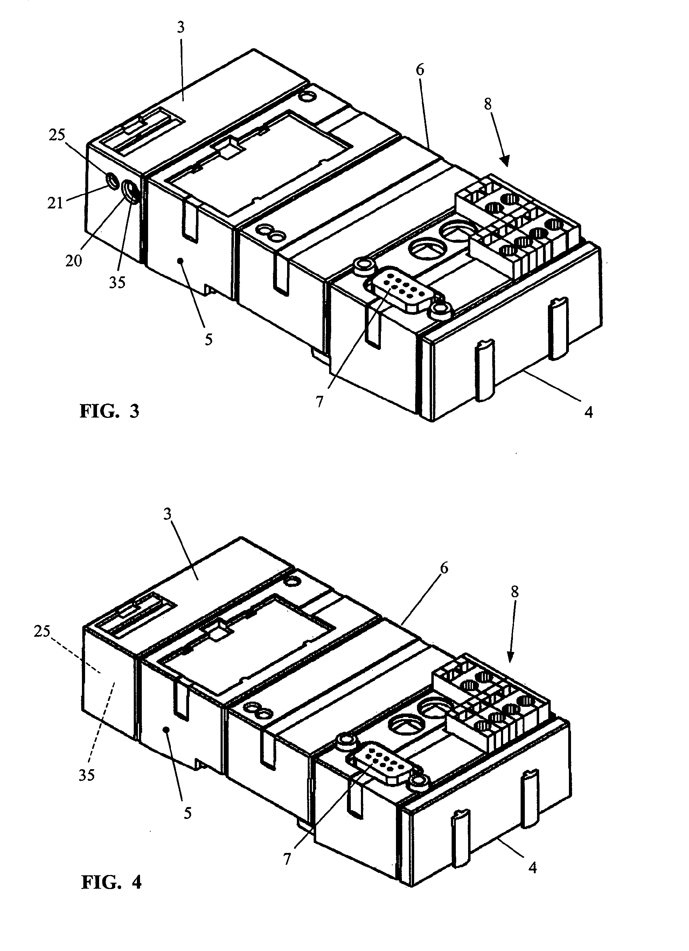

Der Baustein 3 ist als Masterbaustein ausgeführt und in den Fig. 3, 4 und 6 in verschiedenen Ausführungen gezeigt. Der Masterbaustein hat einen Anschluß 7 für einen Datenbus, z.B. einen CAN-Bus, der im Ausführungsbeispiel über eine SUB-D Schnittstelle anzuschließen ist. Ferner sind am Masterbaustein 3 Anschlußklemmen 8 für die Vorsorgungsspannung, z.B. 24 V vorgesehen.

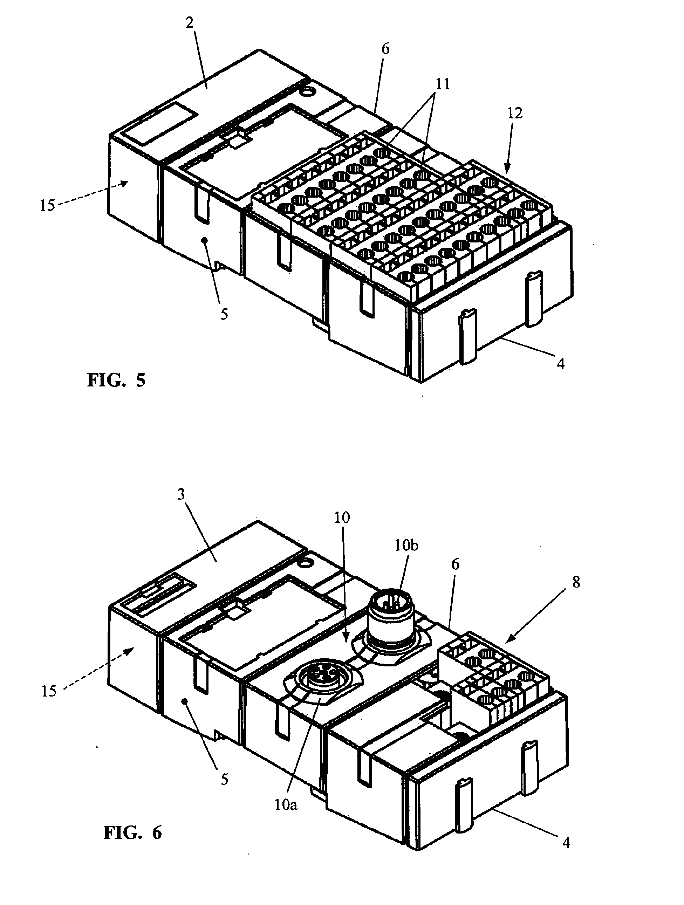

Im Ausführungsbeispiel nach Fig. 6 ist als Anschluß 7 ein mehrpoliger Rundstecker 10 vorgesehen, der mit einem M 12 Gewinde versehen sein kann und über den ein Datenbus durchgeschleift werden kann. Hierzu ist einerseits eine Buchse 10a und andererseits ein Stecker 10b im Gehäuse 4 des Masterbausteins 3 vorgesehen. Wie im Ausführungsbeispiel nach Fig. 3 sind auch hier Anschlußklemmen 8 für eine Spannungsversorgung ausgebildet.

Wie Fig. 1 zeigt, ist der Masterbaustein 3 zwischen Slavebausteinen 2 angeordnet; es kann auch zweckmäßig sein, den Masterbaustein 3 am Anfang oder am Ende einer Reihe von Slavebausteinen 2 anzuordnen.

Jeder Slavebaustein 2 hat, wie in Fig. 5 dargestellt, eine Klemmreihe 11 für Ein-/Ausgänge, die z.B. zur Verbindung mit nicht gezeigten Sensoren und/oder Aktoren vorgesehen sind, sowie eine Klemmreihe 12 zur Spannungsversorgung.

Die modular aufgebaute Steuerung 1 gemäß Fig. 1 ist zum Austausch von Daten und/oder Steuerungsbefehlen mit einem Datenbus 13 verbunden, der am Masterbaustein 3 angeschlossen ist. Der Datenbus 13 ist über den Masterbaustein 3 und die Schnittstellen 15, 16 zu den Slavebausteinen 2 durchgeschleift, so daß der Masterbaustein 3 mit den Slavebausteinen 2 kommunizieren kann.

Zur Verbindung des Datenbusses mit den einzelnen Slavebausteinen 2 weist jeder Baustein 2, 3 - sowohl der Masterbaustein 3 als auch jeder Slavebaustein 2 - Schnittstellen 15, 16 auf, über die die Verbindung des Datenbusses 13 hergestellt wird. So hat der Masterbaustein 3 eine Schnittstelle 16, die auf der einen Gehäuselängsseite 6 (Fig. 1, 2) vorgesehen ist. Der benachbart zur Gehäuselängsseite 6 liegende Masterbaustein 2 hat in seiner dem Masterbaustein 3 zugewandt liegenden Gehäuseseite 5 eine Schnittstelle 15 (Fig. 1), die etwa auf gleicher Höhe H wie die Schnittstelle 16 in der Gehäuseseite 6 des Masterbausteins 3 liegt. Die Schnittstellen 15 und 16 liegen mit geringem Abstand einander gegenüber, wobei keine drahtgebundene elektrische Verbindung zwischen den Schnittstellen 15 und 16 besteht, sondern eine drahtlose Verbindung, so daß die Schnittstellen 15 und 16 drahtlos miteinander in Verbindung treten. Hierzu hat jede Schnittstelle 15, 16 einen Eingang 25, 26 sowie einen Ausgang 35, 36. Dem Eingang 25 auf der einen Gehäuseseite 5 des einen Bausteins 2 (Slavebaustein) liegt ein Ausgang 36 in der Gehäuseseite 6 des anderen Bausteins 3 (Masterbaustein) etwa auf gleicher Höhe H₁ gegenüber. Entsprechend liegt ein Eingang 26 in der Gehäuseseite 6 des einen Bausteins 3 (Masterbaustein) auf einer Höhe H₂ einem Ausgang 35 in der Gehäuseseite 5 des anderen Bausteins 2 (Slavebaustein) gegenüber.

Vorteilhaft hat jeder Baustein 2, 3, also sowohl der Masterbaustein 3 als auch der Slavebaustein 2, auf seinen einander abgewandten Gehäuseseiten 5 und 6 je eine Schnittstelle 15, 16, die auf gleicher Höhe H bezogen auf die Längsmittelachse 14 der Befestigungsschiene 5 liegen. Der Eingang 25 der Schnittstelle 15 liegt mit dem Ausgang 36 der Schnittstelle 16 auf einer Höhe H₁, und der Eingang 26 der Schnittstelle 16 liegt mit dem Ausgang 35 der Schnittstelle 15 auf einer gemeinsamen Höhe H₂.

Werden nun mehrere Bausteine 2 auf einer Befestigungsschiene 5 in einer Reihe nebeneinander angeordnet, so ist über die drahtlosen Schnittstellen 15 und 16 ein Durchschleifen des Datenbusses durch alle Bausteine 2 möglich, wobei jeder Baustein galvanisch getrennt vom nächsten Baustein ist. Dabei wird durch die Umsetzung von der drahtlosen Verbindungsstrecke auf Kupferleitung innerhalb einer Baueinheit 2, 3 das drahtlos empfangene Signal in jedem Baustein aufgefrischt, so daß auch vom Masterbaustein 3 entfernt liegende Slavebausteine 2 mit gleicher Signalstärke angesteuert werden.

In Fig. 2 ist schematisch ein Baustein 2, 3 im Grundaufbau dargestellt, wobei dieser Grundaufbau sowohl für den Masterbaustein 3 als auch für jeden Slavebaustein 2 gilt. Jeder Baustein 2, 3 weist auf der einen Gehäuseseite 5 eine erste Schnittstelle 15 und auf einer anderen, der ersten Gehäuseseite 5 abgewandten Gehäuseseite 6 eine weitere Schnittstelle 16 auf. Wie vorstehend beschrieben, besteht jede Schnittstelle 15 aus einem Eingang 25 und einem Ausgang 35 sowie jede Schnittstelle 16 aus einem Eingang 26 und einem Ausgang 36. Bezogen auf die Längsmittelachse 14 der Befestigungsschiene 5 liegt der Eingang 25 der Schnittstelle 15 auf der Gehäuseseite 5 auf gleicher Höhe H₁ wie der Ausgang 36 der Schnittstelle 16 auf der Gehäuseseite 6. Entsprechend liegt der Eingang 26 der Schnittstelle 16 auf der Gehäuseseite 6 auf gleicher Höhe H₂ wie der Ausgang 35 der Schnittstelle 15 auf der Gehäuseseite 5. Die Gehäuseseiten 5 und 6 liegen zueinander etwa parallel und sind durch die Gehäuselängsseiten des Gehäuses 4 des Bausteins 2, 3 gebildet. Werden nun mehrere Bausteine 2, 3 nebeneinander auf eine Hutschiene 5 befestigt, wie dies in Fig. 1 gezeigt ist, liegt jeder Schnittstelle 15 eine Schnittstelle 16 gegenüber, so daß jedem Eingang 25 ein Ausgang 36 gegenüberliegt bzw. jedem Ausgang 35 ein Eingang 26.

Die Ein- und Ausgänge 25, 26, 35, 36 sind über eine logische Verknüpfung 17 miteinander verbunden, wobei die logische Verknüpfung 17 von einem Microprozessor 18 gesteuert ist, dessen Anschlüsse Tₓ und Rₓ zur Steuerung der Verknüpfung dienen. Für den CAN-Bus wird das Signal Tₓ direkt auf das Rx-Signal zurückgeleitet, wodurch eine Arbitrierung der CAN möglich ist.

Wie Fig. 2 zeigt, ist die drahtlose Verbindung zwischen den einander gegenüberliegenden Ein- und Ausgängen 25/36 und 26/35 im Ausführungsbeispiel nach Fig. 2 als optische Verbindung ähnlich einem Optokoppler gestaltet. Vorzugsweise arbeitet die optische Verbindung im Infrarotbereich, so daß sie keinen Störungen durch Tageslicht unterliegt. Die drahtlosen Verbindungen könnten aber auch in anderer Weise gestaltet werden, z.B. durch eine Funkverbindung, eine induktive Verbindung, eine akustische Verbindung oder dgl..

Wie Fig. 3 zeigt, kann in der Gehäuseseite 5 des Gehäuses 4 des Bausteins 3 eine Öffnung 20, 21 vorgesehen sein. In der anliegenden Gehäuseseite 6 des daneben aufgereihten Bausteins 2 sind entsprechende Öffnungen vorgesehen, so daß die Ein- und Ausgänge der Schnittstellen 15, 16 einander unmittelbar gegenüberliegen und lediglich den Luftspalt zwischen den Ein-/Ausgängen überbrücken müssen.

Vorteilhaft sind die Gehäuse 4 der Bausteine jedoch vollständig geschlossen, wie am Beispiel eines Masterbausteins 3 in Fig. 4 gezeigt ist. Das Gehäuse kann so hermetisch geschlossen und somit vollständig staubfrei gehalten werden, selbst beim Einsatz in stark verschmutzten Bereichen. Die drahtlose Verbindung der Schnittstellen 15 und 16 ist dann so auszubilden, daß die Wandstärke der in der Übertragungsstrecke liegenden Gehäusewände 5 und 6 durchdrungen werden kann. Vorteilhaft sind die Gehäusewände der Bausteine in diesem Bereich der Schnittstellen lichtdurchlässig, insbesondere infrarotdurchlässig, so daß trotz hermetisch abgeschirmter Gehäuse eine sichere Datenübertragung zwischen den Schnittstellen 15 und 16 gegeben ist.

Um eine Reihe von Slavebausteinen 2 am Masterbaustein 3 in Betrieb zu nehmen, werden alle Sendesignale der Slavebausteine 2 abgeschaltet und Slavebaustein für Slavebaustein 2 nacheinander in Betrieb genommen. Jeweils nach erfolgter Initialisierung wird dann das Sendesignal für den intialisierten Slavebaustein 2 in Betrieb genommen. Der Zustand "Licht an" wird dabei als dominant ausgeführt.

Die zur Initialisierung und zum Sende-/Empfangsbetrieb notwendige logische Verknüpfung 17 ist in Fig. 2 gezeigt. Sie besteht im wesentlichen aus fünf UND-Gattern 27, 28, 29, 30 und 31, wobei die UND-Gatter 30, 31 über Steuerleitungen 42 und 43 vom Microprozessor 18 als Ein-/Ausschalter genutzt werden.

Wie bei CAN-Bussen typisch, wird das Sendesignal Tₓ über das UND-Gatter 28 sowie eine Rückkopplungsleitung 40 auf das Gatter 27 des Eingangs 25 geschaltet, dessen Ausgang auf den Empfangseingang Rₓ des Microprozessors 18 geschaltet ist. Die Rückkopplung ist relevant für die Arbitrierung des Busses.

Bei der Inbetriebnahme hat der Microprozessor 18 über die Steuerleitungen 42 und 43 die UND-Gatter 30 und 31 abgeschaltet, so daß kein Sendebetrieb über die Ausgänge 35 und 36 möglich ist.

Über den Eingang 25 werden zunächst vom Masterbaustein 3 Signale empfangen, wobei der Slavebaustein 2 entsprechend adressiert wird, um dann - nach empfangener Adresse - sich über ein Sendesignal Tₓ beim Master zu melden. Mit der Inbetriebnahme schaltet der Microprozessor 18 die Steuerleitungen 42 und 43 frei, so daß die UND-Gatter 30 und 31 durchlässig sind, wodurch entsprechende Signale auch auf den Ausgängen 35 und 36 anliegen. Ein vom Master 3 über den Eingang 25 empfangenes Signal wird über die Leitung 41 dem UND-Gatter 29 aufgeschaltet, welches an seinem anderen Eingang ein Sendesignal Tₓ enthält und die am Eingang 25 empfangenen Signale somit über das freigeschaltete UND-Gatter 30 auf den Ausgang 36 abgibt, wodurch die Eingangssignale auf den Ausgang 36 durchgeschaltet sind. Nachgeordnete Slavebausteine 2 können entsprechend angesteuert, adressiert und in Betrieb genommen werden.

Während des Betriebs werden die Signale - CAN typisch - über den Eingang 26 empfangen und über das UND-Gatter 28 zusammen mit einem Sendesignal Tₓ auf den Ausgang 35 gegeben, sofern der Microprozessor 18 den UND-Baustein 31 freigeschaltet hat. Ein Slavebaustein 2 leitet somit seine Signale vom Eingang 25 auf den Ausgang 36 und gibt die auf den Ausgang 26 empfangenen Signale über den Ausgang 35 wieder ab. Die der Adressierung des Slavebausteins 2 entsprechenden Signale werden im Microprozessor 18 verarbeitet und die entsprechend angeschlossenen Aktoren und/oder Sensoren angesteuert.

## Patentansprüche

1. Modular aufgebaute Steuerung, insbesondere für Fertigungsanlagen, Maschinen oder dgl., mit einem in einem selbständigen Gehäuse (4) angeordneten Masterbaustein (3) und mindestens einem seitlich neben dem Masterbaustein (3) liegenden, in einem selbständigen Gehäuse (4) angeordneten Slavebaustein (2) der mit Ein-und/oder Ausgängen (11) zur Verbindung mit Sensoren und/oder Aktoren versehen ist und der Masterbaustein (3) sowie der Slavebaustein (2) zum Austausch von Daten-und/oder Steuerungsbefehlen über einen Datenbus (13) miteinander kommunizieren, wobei zur Busverbindung der Masterbaustein (3) und der Slavebaustein (2) je eine Schnittstelle (15, 16) aufweisen,
**dadurch gekennzeichnet, daß** die Schnittstelle (16) des Masterbausteins (3) und die Schnittstelle (15) des Slavebausteins (2) etwa auf gleicher Höhe (H) mit geringem Abstand einander gegenüberliegen und die Schnittstellen (15, 16) drahtlos miteinander in Verbindung stehen.

2. Steuerung nach Anspruch 1,
**dadurch gekennzeichnet, daß** auf einer Gehäuseseite (5) des Bausteins (2, 3) eine erste Schnittstelle (15) und auf einer anderen Gehäuseseite (6) des Bausteins (2, 3) eine weitere Schnittstelle (16) vorgesehen ist.

3. Steuerung nach Anspruch 2,
**dadurch gekennzeichnet, daß** die Schnittstelle (15, 16) eines Bausteins (2, 3) auf einander abgewandten, zueinander etwa parallel liegenden Gehäuseseiten (5, 6) des Bausteins (2, 3) liegen.

4. Steuerung nach Anspruch 2 oder 3,
**dadurch gekennzeichnet, daß** die Schnittstelle (15) auf der einen Gehäuseseite (5) und die Schnittstelle (16) auf der anderen Gehäuseseite (6) etwa auf gleicher Höhe (H) liegen.

5. Steuerung nach einem der Ansprüche 1 bis 4,
**dadurch gekennzeichnet, daß** eine Schnittstelle (15, 16) aus einem Eingang (25, 26) und einem Ausgang (35, 36) besteht.

6. Steuerung nach Anspruch 5,
**dadurch gekennzeichnet, daß** dem Eingang (25) auf der einen Gehäuseseite (5) etwa auf gleicher Höhe (H₁) der Ausgang (36) auf der anderen Gehäuseseite (6) zugeordnet ist.

7. Steuerung nach einem der Ansprüche 1 bis 6,
**dadurch gekennzeichnet, daß** die drahtlose Verbindung eine optische Verbindung, vorzugsweise eine Infrarotverbindung ist.

8. Steuerung nach einem der Ansprüche 1 bis 7,
**dadurch gekennzeichnet, daß** zwischen der Schnittstelle (15) des einen Bausteins (2, 3) und der Schnittstelle (16) des anderen Bausteins (2, 3) die Gehäusewände (5, 6) der Bausteine (2, 3) liegen.

9. Steuerung nach Anspruch 8,
**dadurch gekennzeichnet, daß** die Gehäusewände (5, 6) der Bausteine (2, 3) zumindest im Bereich der Schnittstellen (15, 16) lichtdurchlässig, insbesondere infrarotdurchlässig sind.

10. Steuerung nach einem Ansprüche 1 bis 6,
**dadurch gekennzeichnet, daß** die drahtlose Verbindung eine Funkverbindung, eine induktive Verbindung oder eine akustische Verbindung ist.

11. Steuerung nach einem der Ansprüche 1 bis 10,
**dadurch gekennzeichnet, daß** zwischen dem Eingang (25, 26) und dem Ausgang (35, 36) eines Bausteins (2, 3) eine von einem Microprozessor (18) gesteuerte Verknüpfungslogik (17) geschaltet ist.

12. Steuerung nach einem der Ansprüche 1 bis 11,
**dadurch gekennzeichnet, daß** jeder Ausgang (35, 36) eines Slavebausteins (2) über ein Gatter (30, 31) angesteuert ist, und das Gatter (30, 31) nach Empfang einer Adressierung des Slavebausteins (2, 3) freigeschaltet wird.
